# EUROPÄISCHE PATENTSCHRIFT

(11) **EP 2 031 661 B1**
(45) Veröffentlichungstag und Bekanntmachung des Hinweises auf die Patenterteilung: **27.06.2012**
(21) Anmeldenummer: 08156457.7
(22) Anmeldetag: 19.05.2008
(51) Int. Cl.: H01L 31/042

(54) **Photovoltaik-Module mit aus ALU-Rahmenprofilen gefertigten Rahmen**
Photovoltaic module with frames made from ALU framework profiles
Module photovoltaïque doté d'un cadre fabriqué à l'aide de profilés de cadre en aluminium

(30) Priorität: 23.07.2007 DE 202007010330 U
(43) Veröffentlichungstag der Anmeldung: 04.03.2009
(73) Patentinhaber: Schöne, Vera, 33415 Verl (DE)
(72) Erfinder: Henkenjohann, Johann, . (DE)
(74) Vertreter: Cohausz & Florack

(56) Entgegenhaltungen:
- EP-A- 0 419 775
- DE-A1- 3 916 124
- DE-A1- 19 700 873
- DE-C1- 4 141 194
- DE-U1- 9 211 121
- JP-A- 10 317 603
- JP-A- 11 002 004
- JP-A- 2001 107 518
- JP-A- 2001 144 314
- JP-A- 2002 364 136
- JP-A- 2003 343 058
- US-A1- 2007 131 273

## Beschreibung

### Technisches Umfeld

Die Erfindung betrifft Photovoltaik-Module mit in aus Aluminium-Rahmenprofilen gefertigten Rahmen angeordnetem Laminat gemäß dem Oberbegriff des Hauptanspruchs.

Die Energiegewinnung aus der Sonneneinstrahlung ist ein probates Mittel um zur Erzeugung elektrischer Energie die Nutzung fossiler Brennstoffe und der Kernenergie zu beschränken, ist doch die von der Sonne eingestrahlte Energie die einzige, die ohne Zugriff auf irdische Ressourcen in elektrische Energie umgesetzt werden kann. Das Verbrennen fossiler Brennstoffe führt zu unerwünschten CO₂-Emissionen und zur Verringerung der an sich wertvollen Kohle-, Erdöl- und Erdgas-Ressourcen, die Kernenergienutzung zu den mit den radioaktiven Abfallprodukten verbundenen Problemen. Die Sonneneinstrahlung - Folge der in der Sonne ablaufenden Kernfusionsprozessen - ist mit der bis in zumindest mittlere geographische Breiten hinreichenden Solarkonstanten geeignet, einen erheblichen Anteil an Energie bereit zu stellen, wobei dafür neben der Gewinnung thermischer Energie auch die Gewinnung elektrischer Energie aus Photovoltaik-Prozessen zu sehen ist. Zur Umformung von (Licht-)Strahlungsenergie in elektrische Energie sind Solaranlagen mit einer Anzahl von photovoltaischen Modulen bekannt, die zusammengefasst als Dachanlagen oder als Fassadenanlagen eingesetzt werden. Die Module bestehen in aller Regel aus einem mit photovoltaische Zellen bildende Halbleiter versehenem Laminat, das in einem Rahmen aus umlaufenden Profilen angeordnet ist. Diese Halbleiteranordnungen, die zum Schutz mit einer transparenten Schutzschicht abgedeckt sind, sind ihrerseits untereinander elektrisch parallel (oder auch gruppenweise) in Serie geschaltet, um elektrische Energie gewünschter Spannung zu erhalten, wobei die zu entnehmende Leistung von der bereitgestellten Fläche, dem Einstrahlungswinkel und der am Aufstellort herrschenden Solarkonstanten bestimmt ist.

### Stand der Technik

US20070131273 offenbart ein Photovoltaik-Modul, das als Stand der Technik angesehen wird.

Photovoltaikmodule werden, mit Rahmen auf dem Dach oder an der Fassade befestigten Halteprofilen so angeordnet (DE 201 10 459 U1, EP 1 286 401 A2), dass deren (nach EP 1 006 592 A2 auch von einem Rahmen umfassten) Randbereiche in taschenförmigen Aufnahmenuten der Halteprofile "eingeschoben" werden können, wobei diese Art der Halterung vorteilhaft ist, um Dachbewegungen und/oder das unterschiedliche thermische Ausdehnungsverhalten von Dach und Modulen auszugleichen.

Weiter ist das in den Modulen vorgesehene (aktive, das Sonnenlicht in elektrische Energie umwandelnde) Laminat von einem Rahmen eingefasst und in einen solchen so eingesetzt, dass dessen Ränder das Laminat umgreifen. Dadurch entsteht ein Rand, an dem sich bei auf Dächern immer geneigter Lage des Moduls Wasser staut, das auf die Oberfläche der Module gelangend diese bei Abfließen "spült". Dabei nimmt das Wasser auf der Modul-Oberfläche abgelagerte Luft-Verunreinigung mit. Da immer irgendwelche organische Bestanteile vorliegen, kommt es im Laufe der Zeit zu einem Wachstum von Algen, Flechten und anderen niederen Pflanzen, die Teile der Modulfläche abdecken und so den Wirkungsgrad der Module absinken lässt. Durch diese Unterkonstruktion wird auch der für Leitungsführungen erwünschte Raum unter den Photovoltaikmodulen geschaffen, die bei dieser Art der Konstruktion abgedichtet durch das Dach selbst geführt werden.

### Aufgabe

Hier setzt die Erfindung an, dessen Ziel es ist, ein Modul zu schaffen, bei dem die geschilderten Nachteile vermieden sind, und das wirtschaftlich herstellbar und ohne Schwierigkeiten einbaubar ist.

Diese Aufgabenstellung wird für gattungsgemäße Photovoltaikmodule durch die im Kennzeichen des unabhängigen Hauptanspruchs enthaltenen Merkmale gelöst; vorteilhafte Weiterbildungen und bevorzugte Ausführungsformen beschreiben die Unteransprüche.

### Lösung

Als Rahmenprofil für das Laminat wird ein Profil eingesetzt, mit einem die Steifigkeit gewährleistenden Rechteck-Hohlprofil, an das ein Z-Profil so angeformt ist, dass zum einen von einem der Seitenwände des Rechtseckprofils und dem zugeordneten Mittelschenkel des Z-Profils eine taschenförmige Nut gebildet ist, und zum anderen der hoch stehende freie Schenkel des Z-Profils, dessen Höhe der Dicke des Laminats mit einer dieses abdeckenden Glasplatte entspricht, und Anlage für das Laminat mit der dieses abdeckenden Glasplatte bildet. Durch diese Ausbildung kann das Laminat mit der Abdeckung auf den Mittelschenkel des so ausgebildeten Z-Profils so auf- und durch ein untergelegtes Dichtband festgelegt werden, dass die Glasplatte und der hoch stehende freie Schenkel des Z-Profils flächenbündig abschließen. Eine möglicherweise notwendige Randabdichtung kann durch eine umlaufende Dichtschnur gewährleistet werden.

In vorteilhafte Ausbildung liegt die Nut des Rahmenprofils in einer Höhe derart, dass die äußere Oberfläche des die Nut bildenden Mittelschenkels des Z-Profils mit seiner dem Laminat zugewandten Seite die Auflagefläche für das Laminat bildet.

Zur Festlegung auf einem Dach oder an einer Fassade ist eine am Dach bzw. an der Fassade festgelegte Unterkonstruktion mit Halteprofilen vorgesehen. Diese Halteprofile sind bei einer ersten Ausführungsform aus im Wesentlichen T-förmigen Profilen mit rechtwinklig abstehenden Flanschschenkeln gebildet, die vorteilhaft ungleich lang abstehend ausgebildet sind. Bei dieser Ausführungsform erfolgt das Einsetzen der Module mit dem erfindungsgemäßen Rahmen in einfacher Weise dadurch, dass sie auf der einen Seite bis zum Anschlag angesetzt werden, wobei die Abmessung der Module ein Absenken zwischen den beiden einander zugewandten rechtwinklig abstehenden Flanschschenkeln ermöglichen, und ein Einführen des anderen der Flanschschenkel zum Festsetzen des Moduls. Vorteilhaft ist die Weite der Nut so gehalten, dass die Leiste mit leichtem Formschluss einführbar ist. Die gewisse Lose der in die Nuten des Rahmenprofils eingeführten und dort gehaltenen Flanschschenkel gleicht thermische Ausdehnungen aus.

Bei einer zweiten Ausführungsform sind die Halteprofile mit Schraubaufnahmen versehen. Die in diese Schraubaufnahmen einschraubbaren Schrauben sind mit Klemmbrücken versehen, deren abstehende Schenkel in die Nuten eingreifen, die der umlaufenden Rahmen des Moduls aufweist. Bei dieser Ausführungsform erfolgt das Einsetzen der Module mit dem erfindungsgemäßen Rahmen in einfacher Weise dadurch, dass mit den Schrauben die Klemmbrücken so angezogen werden, dass das Modul gegen die Halteprofile gedrückt wird. Auf diese Weise lassen sich mit einem Halteprofil Module verschiedener Stärke in einfacher Weise montieren. - In bevorzugter Ausführungsform sind das Rahmenprofil und das Halteprofil und ggf. auch Profile der Unterkonstruktion gezogene, rollgeformte oder gewalzte Aluminium-Profile.

### Beschreibung der Zeichnungen

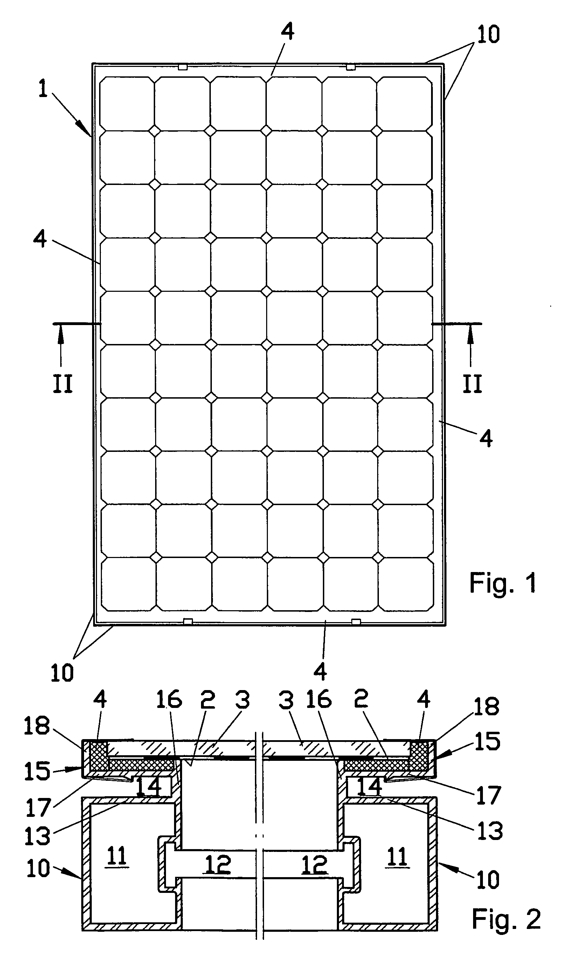

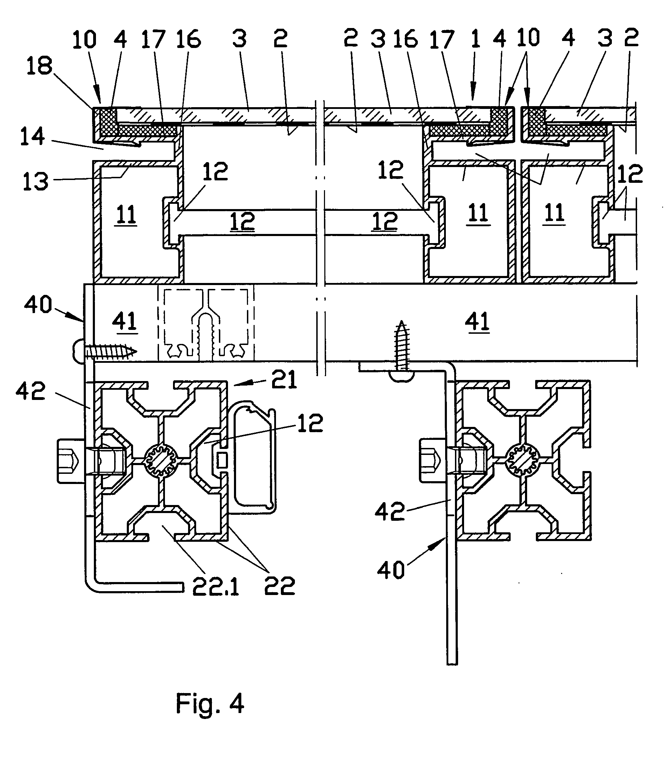

Das Wesen der Erfindung wird an Hand der Figuren 1 bis 8 beispielhaft näher erläutert; dabei zeigen:
- Fig. 01:: Photovoltaikmodul (einzeln, Aufsicht);
- Fig. 02:: Photovoltaikmodul (einzeln, Schnitt II-II);
- Fig. 03:: Photovoltaikmodul auf Dachkonstruktion mit Unterhalterung;
- Fig. 04:: Photovoltaikmodul mit Stützelement gestützt:
- Fig. 05:: Photovoltaikmodul mit Halteprofil (Einzelheit);
- Fig. 06:: Halteprofil mit Einsatz;
- Fig. 07:: Photovoltaikmodul auf Dachkonstruktion;
- Fig. 08:: Photovoltaikmodul (nach Fig. 6 - Ansicht VII-VII);

### Ausführungsbeispiele

Das Photovoltaikmodul 1 ist (in dieser Darstellung) ein rechtwinkliges Gebilde mit einem von einer Glasscheibe 3 abgedeckten Laminat 2, das die Halbleiteranordnung enthält, die Lichtenergie in elektrische Energie umwandelt. Dieses Laminat 2 ist in einem Rahmen 10 angeordnet, der von vier in vorteilhafter Weise stranggepressten Rechteckhohlprofil 11 gebildet ist. In diesem Rahmen 10 ist das Laminat 2 mit der Dichtmasse 4 abgedichtet gehalten. Die inneren Wandungen dieser Rechteckhohlprofile 11 weisen eine Einnehmung 12 auf, in die Kabelhaltereinsätze 12.1 eingesetzt werden können. Rechtwinklig zur inneren Wandung ist das Rechteckhohlprofil 11 von einem Profilschenkel 13 geschlossen, wobei diese innere Wandung des Rechteckhohlprofils 11 über den Profilschenkel hinaus einen ersten, an das Hohlprofil angesetzten Schenkel 16 eines Z-Profils 15 bildet. Der parallel zum Profilschenkel liegende Mittelschenkel 17 bildet eine zur äußeren Seite hin geöffnete Tasche. Das Z-Profil 15 wird durch den freien Schenkel 18 vervollständigt, wobei die Außenseiten vom Mittelschenkel 17 und freiem Schenkel 18 den Auflagewinkel für das mit der Glasscheibe 3 abgedeckte Laminat 2 bildet. Zur Fixierung ist auf dem Auflagewinkel eine Dichtmasse 4 aufgetragen, in die das Laminat 2 mit der Abdeckplatte 3 so eingesetzt ist, dass seine Außenfläche bündig mit der oberen Kante des freien Schenkels 18 liegt, wobei die Dichtmasse 4 nicht über diese Ebene hinaus ragt. Den freien Schenkel 18 übergreifende und am Mittelschenkel 17 abgestützte Sicherungsklammern 18.1 stellen über den Rahmen verteilte Sicherungsmittel dar, die dann zur Wirkung kommen, wenn die Klebung - etwa durch außergewöhnliche Witterungsbedingungen oder Alterungen - versagen sollte.

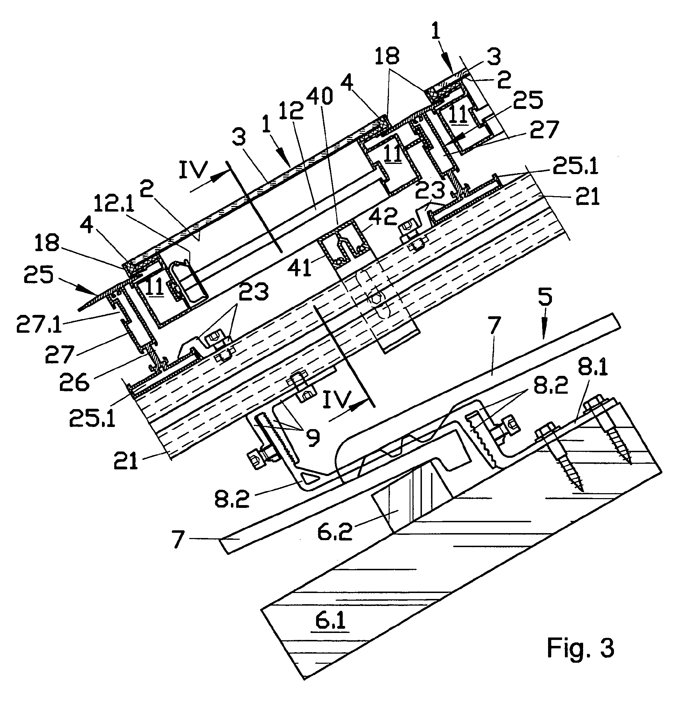

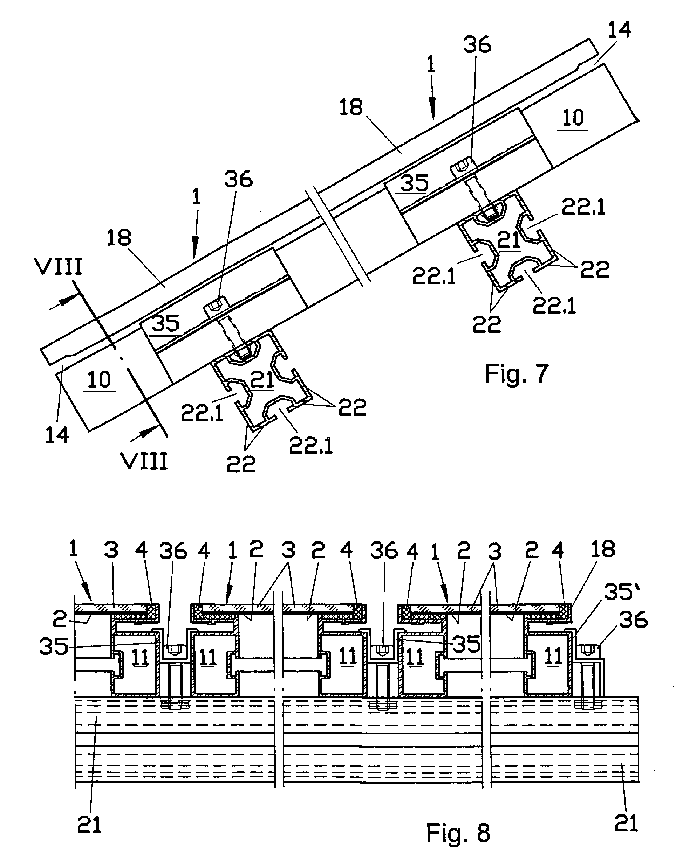

Die Photovoltaikmodule 1 werden auf einer Fassaden- oder Dachkonstruktion angeordnet, wobei in den Figuren 3 und 8 beispielhaft zwei Möglichkeiten dargestellt sind. Die Dachkonstruktion mit geneigter Dachfläche 5 - hier mit Dachsparren 6.1 und Dachlatten 6.2 auf denen die Dachpfannen 7 liegen - ist mit einer Unterkonstruktion zum Halten der Photovoltaikmodule versehen, Bei der Unterkonstruktion 20 erster Art ist ein L-Profil als unterer Dachwinkel 8.1 mit einem ein C-Profil bildenden oberen Dachwinkel 8,2 so verbunden, dass zum einen eine Höhenverstellbarkeit gegeben ist, die über eine Verzahnung fest einstellbar ist, und dass der Mittelschenkel des oberen Dachprofils 8.2 unter einer der Dachpfannen 7 liegend, die Dachdeckung durchdringt. Dabei sind deren Schenkel so abgewinkelt, dass der obere Dachwinkel 8.2 mit seinem Mittelschenkel im Wesentlichen parallel zu den Dachpfannen 7 liegt. An diesen oberen Dachwinkel 8.2 ist - wiederum höhenverstellbar und mittels Verzahnung fixierbar - ein Tragwinkel 9 angesetzt, an den das durchlaufende Tragprofil 21 aufgeschraubt.

Dieses Tragprofil 21 ist als im Wesentlichen quadratisches Hohlprofil ausgebildet, deren Seitenwandungen 22 mit in Profilrichtung verlaufenden Nuten 22.1 versehen ist, die mit Gewindeaufnahmen so versehen sind, dass Befestigungssteine 23 zur Klemmbefestigung der Halteprofile 25 zum Halten der Rahmen 10 der Photovoltaikmodule 1 mittels Schrauben an diesen Tragprofilen fixierbar sind.

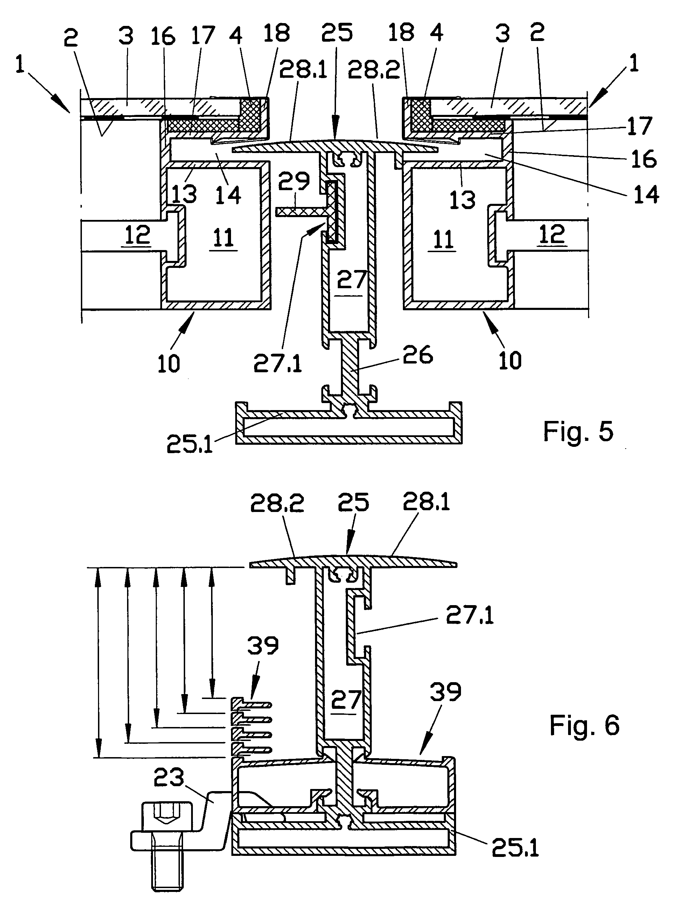

Die Halteprofile 25 sind ebenfalls stranggepresste Hohlprofile mit Fußflansch 25.1. Die Fußflansche 25.1 sitzen auf den Tragprofilen 21 auf und werden mittels der Befestigungssteine 23 an diese angeklemmt. An dem Fußflansch 25.1 ist ein Haltesteg 26 angeformt, der wiederum ein versteifendes Hohlprofil 27 trägt. Das obere Ende dieses Hohlprofils 27 ist mit überstehenden Flanschschenkeln 28.1 und 28.2 versehen, von denen der Flanschschenkel 28.1 der längere und der Flanschschenkel 28.2 der kürzere ist. Die dem längeren Flanschschenkel 28.1 zugeordnete Seite des Hohlprofils 27 kann mit einer Einnehmung 27.1 versehen sein, in die bei Bedarf ein Stützeinsatz 39 passender Höhe eingefügt werden kann. Der Fußflansch 25.1 sowie das dem Fußflansch 25.1 zugeordnete Ende des Haltestegs sind so ausgebildet, dass ein Passeinsatz 29 angesetzt werden kann. Die nach außen weisende Seitenwandung 41 ist mit Ansätzen 42 gewünschter Höhe (wie in Figur 6 angedeutet) verlängert, so dass Photovoltaikmodule 1 auch unterschiedlicher Dicke abgestützt werden können. Zum Einsetzen der Photovoltaikmodule 1 werden diese gekippt angesetzt, so dass der längere, rechtwinklig abstehende Flanschschenkel 28.1 in die Tasche 14 des Rahmens eingreift. Dabei kann das Photovoltaikmodul 1 so tief über den Flanschschenkel 28.1 geführt werden, dass sein gegenüber liegender Rand am kürzeren rechtwinklig abstehenden Flanschschenkel 28.2 vorbei in die von den Halteprofilen 25 gebildete Öffnung gekippt werden kann. Dabei versteht es sich von selbst, dass bei dieser Art der Befestigung die Flanschschenkel so angeordnet werden, dass die kürzeren rechtwinklig abstehenden Flanschschenkel 28.2 in Bezug auf die Dachneigung höher liegend vorgesehen sind, als die längeren rechtwinklig abstehenden Flanschschenkel 28.1.

Bei einer zweiten Befestigungsart - in den Figuren 7 und 8 ohne Dachkonstruktion dargestellt - sind die Photovoltaikmodule 1 mit ihren Rahmen 10 ohne zusätzliche Halteprofile 25 an den Tragprofilen 21 befestigt. Dazu sind auf dem Dach quer zur Dachneigung verlaufende Halteprofile 21 angeordnet, auf denen die Photovoltaikmodule 1 mit ihren Rahmen 10 aufliegen. Die rechtwinklig zu den Halteprofile 21 liegenden Schenkel der Rahmen 10 sind mit den Halteprofilen 21 über Klemmverbindungen verbunden und so an diesen fixiert. Dazu sind im Wesentlichen U-förmige Klemmbrücken 35 vorgesehen, die mit in die Halteprofile 21 einschraubbaren Klemmschrauben 36 an diesen fixiert sind. Die Klemmbrücken 36 weisen an ihren freien Enden abstehende Schenkel 37 auf, die in die Taschen 14 eingreifen und beim Anziehen der Klemmschraube 36 die Rahmen der Module 1 an die Halteprofile 21 ziehen und so klemmend fixieren. Dabei versteht es sich von selbst, dass bei randständigen Photovoltaikmodulen einseitige Klemmbrücken 35' zum Einsatz kommen. Diese sind statt in U-Form in Z-Form ausgebildet, so dass sie sich mit dem freien Schenkel auf dem Tragprofil 21 abstützen.

Um insbesondere bei schwach geneigten Dachkonstruktionen unter Berücksichtigung von auftretenden Lasten wie Schnee- oder Windlast statisch hinreichend gesicherte Aufständerung erreichen zu können, ist eine zusätzliche Stützung vorgesehen. Dazu werden Im Bereich der Photovoltaikmodule 1 quer zur Dachneigung verlaufende Stützprofile 40 vorgesehen, die einen Ansatz 41 aufweisen, der mit Langloch versehen, seitlich am Tragprofil 21 verschraubt ist. Durch das Langloch ist die Einstellung so möglich, dass das Stützprofil 40 kraftschlüssig am Rahmen 10 der Photovoltaikmodule 1 anliegen und diese in der gewünschten Weise abstützen.

### Bezugszeichenliste

- 01:: Photovoltaikmodul
- 02:: Laminat
- 03:: Glasabdeckung
- 04:: Dichtung
- 05:: Dachfläche
- 06.1:: Dachsparren
- 06.2:: Dachlatten
- 07;: Dachpfannen
- 08.1:: untere Dachwinkel
- 08.2: oberer Dachwinkel
- 09: Tragwinkel
- 10:: Rahmen
- 11:: Rechteckhohlprofil
- 12:: C-Einehmung
- 12.1:: Kabelhaltereinsatz
- 13:: die taschenförmige Nut bildender Schenkel
- 14:: Tasche
- 15:: Z-Profil
- 15.1:: Sicherungsklemme
- 16:: erster (an das Hohlprofil angesetzter) Schenkel
- 17:: Mittelschenkel
- 18:: zweiter (freier) Schenkel
- 19::
- 20:: Unterkonstruktion 1. Ausführungsform
- 21:: Tragprofil
- 22:: Seitenwandungen 22
- 22.1: Nuten
- 23:: Befestigungssteine
- 24::
- 25:: Halteprofil
- 25.1:: Fußflansch
- 26:: Haltesteg
- 27:: Hohlprofil zur Aussteifung
- 28.1:: längerer (rechtwinklig abstehender) Flanschschenkel
- 28.2:: kürzerer (rechtwinklig abstehender) Flanschschenkel
- 29:: Stützeinsatz
- 30:: Unterkonstruktion 2. Ausführungsform
- 31:: Halteprofil
- 32:: Schraubaufnahme
- 33:: Schraube
- 35:: Klemmbrücke
- 36:: Klemmschraube
- 37:: abstehende Schenkel
- 38::
- 39:: Passeinsatz
- 40:: Stützelement (verstellbar)
- 41:: Stützprofil
- 42:: Ansatz (mit Langloch)

## Patentansprüche

1. Photovoltaik-Modul mit in einem aus Aluminium-Rahmenprofilen gefertigten Rahmen angeordneten Laminat (2) mit einer von einer Glasplatte (3) abgedeckten Halbleiterschicht, das zumindest mittels einer Dichtung abgedichtet im Rahmen (10) angeordnet ist, insbesondere für auf einem Dach als Sonnenkollektor aufständerbare Photovoltaik-Module, **dadurch gekennzeichnet, dass** als Rahmenprofil (10) für das Laminat (2) ein Rechteck-Hohlprofil (11) mit angesetztem Z-Profil (16, 17, 18) mit einem ersten, hoch stehenden Schenkel (16), einem sich daran anschließenden Mittelschenkel (17) und einem zweiten hoch stehenden freien Schenkel (18) vorgesehen ist, wobei der hoch stehende freie Schenkel (18) des Z-Profils Anlage für das auf den Mittelschenkel (17) des Z-Profils mit als Dichtung (4) untergelegtem Dichtband aufgelegte Laminat (2) mit abdeckender Glasplatte (3) bilden, und wobei dessen Höhe unter Berücksichtigung der Dicke des Dichtbandes (4) und der Dicke von Laminat (1) mit dieses abdeckender Glasplatte (3) so entspricht, dass der hoch stehende freie Schenkel (18) des Z-Profils mit der Oberseite der Glasplatte (3) flächenbündig abschließen.

2. Photovoltaik-Modul nach Anspruch 1, **dadurch gekennzeichnet, dass** der hoch stehende erste Schenkel (16) die zum Inneren des Rahmens (10) gerichtete innere Wandung des Rechteck-Hohlprofils (11) fortsetzt.

3. Photovoltaik-Modul nach Anspruch 1 oder 2, **dadurch gekennzeichnet, dass** das an das Rechteck-Hohlprofil (11) angesetzte Z-Profil (16, 17, 18) angeformt ist.

4. Photovoltaik-Modul nach Anspruch 1, 2 oder 3, **dadurch gekennzeichnet, dass** zur Randabdichtung des aufgesetzten Photovoltaik-Moduls (1) im Rahmen (10) eine unter- und auch seitlich eingelegte umlaufende Dichtschnur (4) vorgesehen ist.

5. Photovoltaik-Modul nach einem der Ansprüche 1 bis 4, **dadurch gekennzeichnet, dass** die in den Rahmen (10) eingesetzten Photovoltaik-Module (1) mit Federklammern gesichert sind.

6. Photovoltaik-Modul nach einem der Ansprüche 1 bis 5, **dadurch gekennzeichnet, dass** von der dem Z-Profil (16, 17, 18) zugewandten Seitenwand des Rechteck-Hohlprofils (11) zusammen mit dem zugeordneten Mittelschenkel (16) des Z-Profils eine von dem hoch stehenden ersten Schenkel (16) des Z-Profils geschlossene, nutförmig umlaufende Tasche (14) des Rahmens (10) zur Aufnahme von Befestigungsmitteln gebildet ist.

7. Photovoltaik-Modul nach einem der Ansprüche 1 bis 6, **dadurch gekennzeichnet, dass** die der Innenseite des Rahmens zugewandte Wandung des Rechteck-Hohlprofils eine Nut (12) aufweist, zur Aufnahme von Haltern für Kabel o. dgl.

8. Photovoltaikanlage mit in Reihen und Spalten angeordneten Photovoltaik-Modulen nach einem der Ansprüche 1 bis 7, **gekennzeichnet durch** eine der Dachneigung angepasste Unterkonstruktion mit zumindest einigen im Maß der Längen der Photovoltaik-Module voneinander beabstandet angeordneten Tragprofilen (21), einem in Sparrenrichtung verlaufenden Tragprofil (21) auf denen im Wesentlichen T-förmige Halteprofile (25) so festgelegt sind, dass deren Haltestege (26) zwischen den Reihen der Photovoltaik-Module liegen, wobei deren kopfseitig angeordnete Flanschschenkel (28.1, 28.2) in die taschenförmige Nut (14) der umlaufenden Rahmen (10) der Photovoltaik-Module (1) eingreifen.

9. Photovoltaikanlage nach Anspruch 8, **dadurch gekennzeichnet, dass** quer zu den Tragprofilen (21) verlaufende Halteprofile (25) vorgesehen sind.

10. Photovoltaikanlage nach Anspruch 9,**dadurch gekennzeichnet, dass** die Flanschschenkel (28.1, 28.2) eine Gesamtlänge aufweisen, die kleiner ist, als die Gesamttiefe der einander gegenüberstehenden taschenförmigen Nuten (14), wobei vorzugsweise die Flanschschenkel (28.1, 28.2) eines jeden der Halteprofile (25) ungleich lang sind und so ein "Einkippen" der gerahmten Photovoltaik-Module (1) in die durch auf eine Unterkonstruktion aufgesetzten Halteprofils (25) gebildeten Halterungen ermöglichen.

11. Photovoltaikanlage nach Anspruch 10, **dadurch gekennzeichnet, dass** die Weite der taschenförmigen Nuten (14) so gehalten ist, dass die Flanschschenkel (28.1, 28.2) in diese mit leichtem Formschluss einführbar sind.

12. Photovoltaikanlage nach Anspruch 9, **dadurch gekennzeichnet, dass** die Halteprofile (31) Schraubaufnahmen (32) aufweisen, in die Schrauben (33) mit Klemmbrücken (35) einschraubbar sind, deren abstehende Schenkel (37) in die taschenförmige Nut (14) der umlaufenden Rahmen (10) der Photovoltaik-Module (1) eingreifen.

13. Photovoltaikanlage nach einem der Ansprüche 8 bis 12, **dadurch gekennzeichnet, dass** Rahmenprofil wie Tragprofil (21) oder Halteprofile (22) und ggf. auch Profile der Unterkonstruktion, sowie unterer und oberer Dachwinkel (8, 9) gezogene, rollgeformte oder gewalzte Aluminium-Profile sind.

## Claims

1. Photovoltaic module having, arranged in a frame made of profiled aluminium frame sections, a laminate (2) which comprises a semiconductor layer covered by a glass plate (3) and is arranged sealed in the frame (10) at least by means of a seal, in particular for photovoltaic modules which can be installed as a solar collector on a roof, **characterised in that** a rectangular hollow profiled section (11) having, attached to it, a Z-shaped profiled section (16, 17, 18) comprising a first vertical branch (16), a central branch (17) following on therefrom and a free second vertical branch (18), is provided as the profiled frame section (10) for the laminate (2), the free vertical branch (18) of the Z-shaped profiled section forming a support for the laminate (2), with the covering glass plate (3), placed on the central branch (17) of the Z-shaped profiled section with a sealing strip placed underneath as a seal (4), and its height corresponding while taking into account the thickness of the sealing strip (4), to the thickness of the laminate (1) with the glass plate (3) covering it so that the free vertical branch (18) of the Z-shaped profiled section ends flush with the upper side of the glass plate (3).

2. Photovoltaic module according to Claim 1, **characterised in that** the first vertical branch (16) forms a continuation of the inner wall, directed towards the interior of the frame (10), of the rectangular hollow profiled section (11).

3. Photovoltaic module according to Claim 1 or 2, **characterised in that** the Z-shaped profiled section (16, 17, 18) attached to the rectangular hollow profiled section (11) is formed integrally.

4. Photovoltaic module according to Claim 1, 2 or 3, **characterised in that** a circumferential sealing bead (4) placed underneath and interposed laterally is provided for edge sealing of the photovoltaic module (1) placed in the frame (10).

5. Photovoltaic module according to one of Claims 1 to 4, **characterised in that** the photovoltaic modules (1) inserted into the frame (10) are secured by spring clamps.

6. Photovoltaic module according to one of Claims 1 to 5, **characterised in that** a groove-shaped circumferential cavity (14) of the frame (10), which is closed by the first vertical branch (16) of the Z-shaped profiled section, for receiving fastening means, is formed by the side wall of the rectangular hollow profiled section (11), facing the Z-shaped profiled section (16, 17, 18), together with the associated central branch (16) of the Z-shaped profiled section.

7. Photovoltaic module according to one of Claims 1 to 6, **characterised in that** the wall of the rectangular hollow profiled section facing the interior of the frame comprises a groove (12) for receiving holders for cables or the like.

8. Photovoltaic system comprising photovoltaic modules according to one of Claims 1 to 7 arranged in rows and columns, **characterised by** a substructure adapted to the roof slope and comprising at least some profiled bearing sections (21) arranged separated from one another in accordance with the lengths of the photovoltaic modules, and a profiled bearing section (21) which extends in the rafter direction and on which essentially T-shaped profiled retaining sections (25) are fastened so that their retaining webs (26) lie between the rows of photovoltaic modules, the flange branches (28.1, 28.2) thereof arranged on the head side engaging in the cavity-shaped groove (14) of the circumferential frames (10) of the photovoltaic modules (1).

9. Photovoltaic system according to Claim 8, **characterised in that** profiled retaining sections (25) extending transversely to the profiled bearing sections (21) are provided.

10. Photovoltaic system according to Claim 9, **characterised in that** the flange branches (28.1, 28.2) have a total length which is less than the total depth of the cavity-shaped grooves (14) facing one another, the flange branches (28.1, 28.2) of each of the profiled retaining sections (25) preferably being of an equal length so that the framed photovoltaic modules (1) can "tilt" into the holders formed by profiled retaining sections (25) placed on a substructure.

11. Photovoltaic system according to Claim 10, **characterised in that** the width of the cavity-shaped grooves (14) is kept so that the flange branches (28.1, 28.2) can be inserted into them with a slight form fit.

12. Photovoltaic system according to Claim 9, **characterised in that** the profiled retaining sections (31) comprise threaded recesses (32) into which screws (33) with bridging clamps (35) can be screwed, the protruding branches (37) of which engage in the cavity-shaped groove (14) of the circumferential frames (10) of the photovoltaic modules (1).

13. Photovoltaic system according to one of Claims 8 to 12, **characterised in that** the profiled frame section like the profiled bearing section (21) or profiled retaining sections (22) and optionally profiled sections of the substructure, as well as lower and upper roof brackets (8, 9), are drawn, roll-formed or rolled profiled aluminium sections.

## Revendications

1. Module photovoltaïque, avec un stratifié (2), qui est agencé dans un cadre fabriqué en profilés d'aluminium, avec une couche semi-conductrice, qui, recouverte par une plaque de verre (3), est agencée dans le cadre (10), de manière étanche, avec au moins un joint d'étanchéité, en particulier module photovoltaïque, qui peut être installé, sur un toit, en tant que collecteur solaire, **caractérisé en ce que**, comme cadre (10) pour le stratifié (2), est prévu un profilé creux rectangulaire (11), sur lequel est rapporté un profilé en Z (16, 17, 18), comprenant une branche verticale (16), une branche centrale (17), y raccordée, et une deuxième branche verticale, libre (18), sachant que la deuxième branche verticale, libre (18) forme une surface d'appui pour le stratifié (2), pourvu d'une plaque de verre (3) et placé sur la branche centrale (17) du profilé en Z, avec une bande d'étanchéité, en tant que joint d'étanchéité (4), et sachant que sa hauteur, compte tenu de l'épaisseur de la bande d'étanchéité (4) et de l'épaisseur du stratifié (2), y compris la plaque de verre (3), qui le recouvre, est telle que la deuxième branche verticale, libre (18) du profilé en Z est en affleurement avec la face supérieure de la plaque de verre (3).

2. Module photovoltaïque selon la revendication 1, **caractérisé en ce que** le branche verticale (16) prolonge la paroi intérieure du profilé creux rectangulaire, rapporté (11), qui est orientée vers l'intérieur du cadre (10).

3. Module photovoltaïque selon revendication 1 ou 2, **caractérisé en ce que** le profilé en Z rapporté (16, 17, 18) sur le profilé creux rectangulaire (11) est formé à partir de celui-ci.

4. Module photovoltaïque selon revendication 1, 2 ou 3, **caractérisé en ce que**, pour étanchéifier le bord du module photovoltaïque (1) monté, est prévu, dans le cadre (10), un cordon d'étanchéité (4) périphérique, qui est encastré en bas et latéralement.

5. Module photovoltaïque selon l'une des revendications 1 à 4, **caractérisé en ce que** le module photovoltaïque (1), inséré dans le cadre (10), est sécurisé au moyen de crampons élastiques.

6. Module photovoltaïque selon l'une des revendications 1 à 5, **caractérisé en ce qu'**une poche périphérique, de type rainure (14) du cadre (10), destinée à la réception de moyens de fixation, est formée par la paroi latérale du profilé creux rectangulaire (11), orientée vers le profilé en Z (16, 17, 18), en commun avec la branche verticale (16) du profilé en Z associé.

7. Module photovoltaïque selon l'une des revendications 1 à 6, **caractérisé en ce que** la paroi du profilé creux rectangulaire, orientée vers la face intérieure du cadre, est dotée d'une rainure (12), qui est destinée à recevoir des porte-câbles.

8. Installation photovoltaïque avec des modules photovoltaïques selon l'une des revendications 1 à 7, qui sont disposés en rangées et en colonnes, **caractérisée par** une sous-structure, adaptée à la pente du toit, qui est dotée d'au moins plusieurs profilés de support (21) qui sont disposés à distance les uns des autres, à mesure de la longueur des modules photovoltaïques, et d'un profilé de support (21), qui s'étend dans la direction des chevrons, profilés sur lesquels sont fixés des profilés de retenue (25), sensiblement en forme de T, de sorte que leurs pattes de fixation (26) soient situées entre les rangées de modules photovoltaïques, sachant que leurs ailes (28.1, 28.2), disposées côté tête, s'engagent dans les rainures en forme de poche (14) des surfaces d'appui (14, 15) périphériques (10) des modules photovoltaïques (1).

9. Installation photovoltaïque selon la revendication 8, **caractérisée en ce que** sont prévus des profilés de retenue (25), qui s'étendent transversalement par rapport aux profilés de support (21).

10. Installation photovoltaïque selon la revendication 9, **caractérisée en ce que** les ailes (28.1, 28.2) présentent une longueur totale, qui est inférieure à la profondeur totale des rainures en forme de poches (14) opposées, sachant que, de préférence, les ailes (28.1, 28.2) de chacun des profilés (25) sont de longueur inégale et permettent ainsi un « culbutage » des modules photovoltaïques encadrés (1) dans les attaches, qui sont formées par les profilés de retenue (25), installés sur une sous-structure.

11. Installation photovoltaïque selon la revendication 10, **caractérisée en ce que** la largeur des rainures en forme de poches (14) sont conçues de sorte que les ailes (28.1, 28.2) puissent y être insérées en léger emboîtement.

12. Installation photovoltaïque selon la revendication 9, **caractérisée en ce que** les profilés de retenue (31) présentent des logements de vis (32), dans lesquels les vis (33) peuvent être vissées avec des pattes de serrage (35), dont les branches écartées (37) s'engagent dans la rainure en forme de poche (14) du cadre périphérique (10) des modules photovoltaïques (1).

13. Installation photovoltaïque selon l'une des revendications 8 a 12, **caractérisée en ce que** le profilé d'encadrement, de même que le profilé de support (21) ou les profilés de retenue (22) et, le cas échéant, également des profilés de la sous-structure, ainsi que d'angles de toit inférieurs et supérieurs (8, 9) sont des profilés d'aluminium étirés, formés par galets ou laminés.
